# EUROPEAN PATENT SPECIFICATION

(11) **EP 4 384 874 B1**
(45) Date of publication and mention of the grant of the patent: **14.10.2026**
(21) Application number: 22761115.9
(22) Date of filing: 02.08.2022
(51) Int. Cl.: G02B 7/182, G03F 7/20, G02B 17/06

(54) **OPTICAL ELEMENT, PROJECTION OPTICAL UNIT AND PROJECTION EXPOSURE APPARATUS**
OPTISCHES ELEMENT, OPTISCHE PROJEKTIONSEINHEIT UND PROJEKTIONSBELICHTUNGSVORRICHTUNG
ÉLÉMENT OPTIQUE, UNITÉ OPTIQUE DE PROJECTION ET APPAREIL D'EXPOSITION PAR PROJECTION

(30) Priority: 13.08.2021 DE 102021208879
(43) Date of publication of application: 19.06.2024
(73) Proprietor: Carl Zeiss SMT GmbH, 73447 Oberkochen (DE)
(72) Inventor: KUGLER, Jens, 73431 Aalen (DE); NEFZI, Marwene, 52076 Aachen (DE); FETZER, Matthias, 70469 Stuttgart (DE)
(74) Representative: HKW Intellectual Property PartG mbB
(86) International application number: PCT/EP2022/071722
(87) International publication number: WO 2023/016870

(56) References cited:
- WO-A2-2013/120839
- CN-A- 110 187 467
- US-A1- 2014 327 895
- US-A1- 2017 153 552
- US-A1- 2017 363 861
- NI YINGXUE ET AL: "Deflection angle detecting system for the large-angle and high-linearity fast steering mirror using quadrant detector", OPTICAL ENGINEERING, vol. 57, no. 2, 024110, 26 February 2018 (2018-02-26), 1000 20th St. Bellingham WA 98225-6705 USA, pages 1 - 9, XP093147081, ISSN: 0091-3286, DOI: 10.1117/1.OE.57.2.024110
- SANDERS ET AL: "Design and fabrication of a MEMS mirror for Miniature Laser", SPIE, PO BOX 10 BELLINGHAM WA 98227-0010 USA, 6 February 2009 (2009-02-06), XP040492956

## Description

The present invention relates to an optical element for a projection exposure apparatus, to a projection optical unit having such an optical element, and to a projection exposure apparatus having such an optical element and/or such a projection optical unit.

Microlithography is used for producing microstructured components, such as, for example, integrated circuits. The microlithography process is performed using a lithography apparatus, which has an illumination system and a projection system. The image of a mask (reticle) illuminated by means of the illumination system is in this case projected by means of the projection system onto a substrate, for example a silicon wafer, which is coated with a light-sensitive layer (photoresist) and arranged in the image plane of the projection system, in order to transfer the mask structure to the light-sensitive coating of the substrate.

Driven by the desire for ever smaller structures in the production of integrated circuits, EUV lithography apparatuses that use light with a wavelength in the range from 0.1 nm to 30 nm, in particular 13.5 nm, are currently under development. In the case of such EUV lithography apparatuses, because of the high absorption of light of this wavelength by most materials, reflective optical units, that is to say mirrors, must be used instead of - as previously - refractive optical units, that is to say lens elements.

The trend in future projection systems for the EUV range is towards high numerical apertures (NA). The expectation is therefore that the optical surfaces, and hence the mirrors, will become larger. This trend makes the object of a high control bandwidth more difficult since the latter depends, inter alia, on the first internal natural frequency of the respective mirror body. Low natural frequencies lead to the sensors required for the closed-loop control starting to vibrate in the low frequency range. Consequently, the rigid body closed-loop control is already unstable at low frequencies.

It is possible to show that the first natural frequency ω of a cylindrical mirror body is proportional to a thickness d of the respective mirror and inversely proportional to the square of a radius r of the optical surface. This is due to the fact that the mass is proportional to d*r² and the stiffness is proportional to d³/r². An optically active surface with the radius r therefore requires a mirror body volume proportional to r⁴ if the first natural frequency, and hence the control bandwidth of the mirror, may not be reduced. Since material costs are proportional to the substrate volume, the demand for a high control bandwidth becomes ever more expensive. This needs to be improved.

WO 2013/120839 A2 describes a device for the magnetic-field-compensated positioning of a component. The device comprises a holding unit for mounting the component and means for at least partly compensating for an external magnetic field in the region of the holding unit.

MOEMS and Miniaturized Systems VIII, edited by David L. Dickensheets, Harald Schenk, Wibool Piyawattanametha, Proc. of SPIE Vol. 7208, Sanders R. "Design and fabrication of a MEMS mirror for Miniature Laser Projection" 72080R (2009), describes the design and fabrication of a MEMS mirror for miniature laser projection.

US 2014/0327895 A1 describes an optical component comprising a mirror array having a multiplicity of mirror elements, which each have at least one degree of freedom of displacement, and which are each connected to at least one actuator for displacement, having a multiplicity of local regulating devices for damping oscillations of the mirror elements, wherein each of the regulating devices in each case has at least one capacitive sensor having at least one moveable electrode and at least one electrode arranged rigidly relative to the carrying structure.

US 2017/0153552 A1 describes a mirror module comprising a mirror body and a supporting structure having materials with different stiffness.

Against this background, it is an object of the present invention to make available an improved optical element.

Accordingly, an optical element for a projection exposure apparatus is proposed. The optical element comprises a mirror body having an optically active surface, the mirror body comprising a base portion which carries a sensor system and an edge portion on which actuator connectors for connecting actuators to the optical element are provided, the base portion having greater stiffness in comparison with the edge portion, and the mirror body comprising a stiffening rib structure attached to the edge portion on a back side thereof, wherein the back side faces away from the optically active surface, and wherein the rib structure supports the edge portion on the base portion.

As a result of the base portion having a greater stiffness in comparison with the edge portion, said base portion can serve as a connection point for the sensor system. As a result, rigid body movements of the optical element can be detected to the best possible extent and without impairing natural vibrations using measurement technology. The less stiff edge portion can be hollowed out to save weight.

The optical element is preferably a mirror. In particular, the optical element is a part of a projection optical unit of the projection exposure apparatus. By way of example, the mirror body can be manufactured from a ceramic or a glass ceramic material. The optically active surface is suitable for reflecting EUV radiation.

The optically active surface is a mirror surface, in particular. The optically active surface can be applied to the mirror body with the aid of a coating method.

The base portion is preferably in the form of a block-shaped or cylindrical solid body, which is significantly more massive in comparison with the edge portion. The sensor system is attached to the base portion. The edge portion is preferably panel-shaped or slab-shaped and has a significantly lower material strength in comparison with the base portion. As a result, the edge portion is substantially softer in comparison with the base portion. The "stiffness" in the present case is quite generally understood to mean the resistance of a body to elastic deformation due to a force or a torque. The stiffness can be influenced by the utilized geometry and the utilized material. In the present case, the edge portion has a thinner wall in comparison with the base portion, this yielding the lower stiffness of the edge portion in comparison with the base portion.

The optical element preferably has six degrees of freedom. In particular, the optical element has three translational degrees of freedom along an x-direction, a y-direction and a z-direction. Additionally, the optical element has three rotational degrees of freedom, in each case around the x-direction, the y-direction and the z-direction. In the present case, a "position" of the optical element is to be understood as its coordinates or the coordinates of a measurement point provided on the optical element with respect to the x-direction, the y-direction and the z-direction. In the present case, the "orientation" of the optical element is to be understood as its tilt or the tilt of the measurement point about the x-direction, the y-direction and the z-direction. In the present case, the "pose" is to be understood to be both the position and the orientation of the optical element.

With the aid of the actuators, it is possible to influence or adjust the pose of the optical element. For example, the optical element can be moved from an actual pose into a target pose. "Adjusting" or "aligning" can be understood to mean moving the optical element from its actual pose to its target pose. The actuator connectors are preferably provided on the edge portion. By way of example, what are known as Lorentz actuators can be used as actuators and are coupled to the actuator connectors.

According to an embodiment, the optically active surface is provided on the front side of the edge portion, with the actuator connectors being provided on the back side of the edge portion.

The optically active surface can be flat. The optically active surface can also be curved, for example toroidally curved. Preferably, three such actuator connectors are provided, and are arranged in triangular fashion.

The mirror body comprises a stiffening rib structure attached to the back side of the edge portion.

With the aid of the rib structure, it is possible to stiffen the edge portion at least in portions and at the same time obtain a low weight of the optical element. As mentioned above, "the back side" means facing away from the optically active surface.

According to a further embodiment, the rib structure comprises a honeycomb geometry.

In particular, this means that the rib structure has a plurality of different ribs or rib portions which merge into one another or intersect one another, and consequently form honeycomb regions. Honeycombs of the honeycomb geometry may have any desired shape.

According to a further embodiment, the rib structure is connected to the actuator connectors in order to stiffen the latter.

An undesired deformation of the edge portion in the region of the actuator connectors is prevented as a result. There is local stiffening. By way of example, the actuator connectors are formed as cylindrical geometries which protrude from the back side of the edge portion. Parts of the rib structure are securely connected to these cylindrical geometries such that there is an increased stiffness around the actuator connectors in comparison with the remainder of the edge portion.

According to a further embodiment, the sensor system comprises measurement targets that are configured to interact with a measuring beam of a measuring instrument.

By way of example, the measurement targets can be mirrors or have a reflective surface. By way of example, the measuring instrument can be an interferometer. With the aid of the measuring instrument or with the aid of a plurality of measuring instruments, the pose of the optical element is detectable by way of the measurement targets. In addition to the measurement targets, the sensor system may comprise any desired type of sensors.

According to a further embodiment, the actuator connectors are provided at the edge of the edge portion.

In the present case, "at the edge" is to mean that the actuator connectors are placed as close as possible to an edge or an outer rim of the edge portion.

According to a further embodiment, the edge portion is slab-shaped, with the base portion being block-shaped.

By way of example, the base portion can be a cylinder with an oval base. However, the base portion can also be cuboid. In principle, the base portion can have any desired geometry. In particular, the edge portion is slab-shaped or has a significantly thinner wall in comparison with the base portion. The base portion extends out of the edge portion on the back side.

According to a further embodiment, the edge portion has a thinner wall than the base portion.

By way of example, the edge portion can have a thinner wall than the base portion by a factor of 5, 10 or 15. As a result, the edge portion is substantially softer than the base portion, with the edge portion however being able to be stiffened at least in portions with the aid of the rib structures.

According to a further embodiment, the mirror body is a monolithic component.

In the present case, "monolithic", "in one piece" or "one-piece" means that the mirror body forms a common component and is not composed of different component parts. Further, the mirror body can also be constructed materially in one piece. In the present case "materially in one piece" means here that the mirror body is produced from the same material throughout.

According to a further embodiment, the mirror body is a multi-part component.

By way of example, the mirror body may in this case include a plurality of components in the form of the base portion, the edge portion and/or the rib structures. From this, there is also the option of manufacturing the components of the mirror body from different materials. By way of example, it is possible to use materials with different coefficients of thermal expansion. By way of example, one component of the mirror body may consist of a material with a coefficient of thermal expansion of zero and at least one further component may be manufactured from an easily processable and cost-effective material, which is suitable for a light structure. By way of example, it is possible to use different ceramic materials. In this case, it is possible to provide active cooling in order to compensate the differences in the coefficient of thermal expansion between the various materials.

According to a further embodiment, the base portion and the edge portion are bonded to one another at a bonding surface in the case where the mirror body is a multi-part component.

Additionally, the rib structures with respective bonding surfaces also can be bonded to the base portion and the edge portion. Adhesive bonding is also conceivable. In principle, the mirror body may be composed from many simple individual parts. Various joining methods can be used for the purposes of putting together the individual parts. By way of example, it is possible to use adhesion, screen printing, laser bonding, surface activated bonding, and not a bonding, glass frit bonding, adhesive bonding, eutectic bonding, reactive bonding, silicate bonding or the like.

According to a further embodiment, the mirror body is actively cooled.

By way of example, active cooling can be realized or implemented by virtue of the optical element or the mirror body having cooling channels through which a coolant, for example water, is guided in order to cool or heat the optical element or the mirror body. In this case, "active" means that, in particular, the coolant is pumped through the cooling channels with the aid of a pump or the like in order to extract heat from or supply heat to the optical element or the mirror body. However, heat is preferably extracted from the optical element or the mirror body in order to cool said optical element or said mirror body.

According to a further embodiment, cooling channels are guided through the mirror body for the purposes of actively cooling the mirror body.

By way of example, the cooling channels are provided in the base portion of the mirror body. However, the cooling channels may also be provided in the edge portion and/or in the rib structures. Any desired number of cooling channels may be provided. The cooling channels preferably form a cooling circuit or are part of a cooling circuit. The cooling circuit may comprise the aforementioned pump. The coolant circulates in the cooling circuit.

Further, a projection optical unit for a projection exposure apparatus having at least one such optical element and a plurality of actuators is proposed, which actuators are connected to the actuator connectors for the purposes of adjusting the optical element.

The projection optical unit may have a multiplicity of such optical elements. By way of example, the projection optical unit may comprise six, seven or eight such optical elements. The actuators can be what are known as Lorentz actuators. In the present case, "adjusting" or "aligning" is to be understood to mean moving the optical element from its actual pose to its target pose.

According to an embodiment, the projection optical unit further comprises at least one measuring instrument which interacts with the sensor system in order to detect a pose of the optical element.

By way of example, the measuring instrument can be an interferometer. In this case, the sensor system can be a measurement target. By way of example, the actual pose of the optical element can thus be detected with the aid of the measuring instrument and the sensor system. Then, the optical element can be moved from the actual pose to its target pose with the aid of the actuators.

Further, a projection exposure apparatus having at least one such optical element and/or one such projection optical unit is proposed.

The projection exposure apparatus may comprise any desired number of optical elements. The projection exposure apparatus can be a EUV lithography apparatus. EUV stands for "extreme ultraviolet" and denotes a wavelength of the working light of between 1.0 nm and 30 nm. The projection exposure apparatus can also be a DUV lithography apparatus. DUV stands for "deep ultraviolet" and denotes a wavelength of the working light of between 30 nm and 250 nm.

"A(n); one" in the present case should not necessarily be understood as restrictive to exactly one element. Rather, a plurality of elements, such as, for example, two, three or more, can also be provided. Any other numeral used here, too, should not be understood to the effect that there is a restriction to exactly the stated number of elements. Rather, numerical deviations upwards and downwards are possible, unless indicated to the contrary.

The embodiments and features described for the optical element are correspondingly applicable to the proposed projection optical unit and to the proposed projection exposure apparatus, and vice versa.

Further possible implementations of the invention also comprise not explicitly mentioned combinations of any features or embodiments that are described above or below with respect to the exemplary embodiments, as long as covered by the appended claims. In this case, a person skilled in the art will also add individual aspects as improvements or supplementations to the respective basic form of the invention.

Further advantageous configurations and aspects of the invention are the subject matter of the dependent claims and also of the exemplary embodiments of the invention described below. In the text that follows, the invention will be explained in more detail on the basis of preferred embodiments with reference to the accompanying figures.
Fig. 1 shows a schematic meridional section of a projection exposure apparatus for EUV projection lithography;
Fig. 2 shows a schematic view of an embodiment of an optical element for the projection exposure apparatus in accordance with Figure 1;
Fig. 3 shows a schematic bottom view of the optical element in accordance with Fig. 2; and
Fig. 4 shows a schematic view of a further embodiment of an optical element for the projection exposure apparatus in accordance with Figure 1.

Unless indicated to the contrary, elements that are the same or functionally the same have been provided with the same reference signs in the figures. It should also be noted that the illustrations in the figures are not necessarily true to scale.

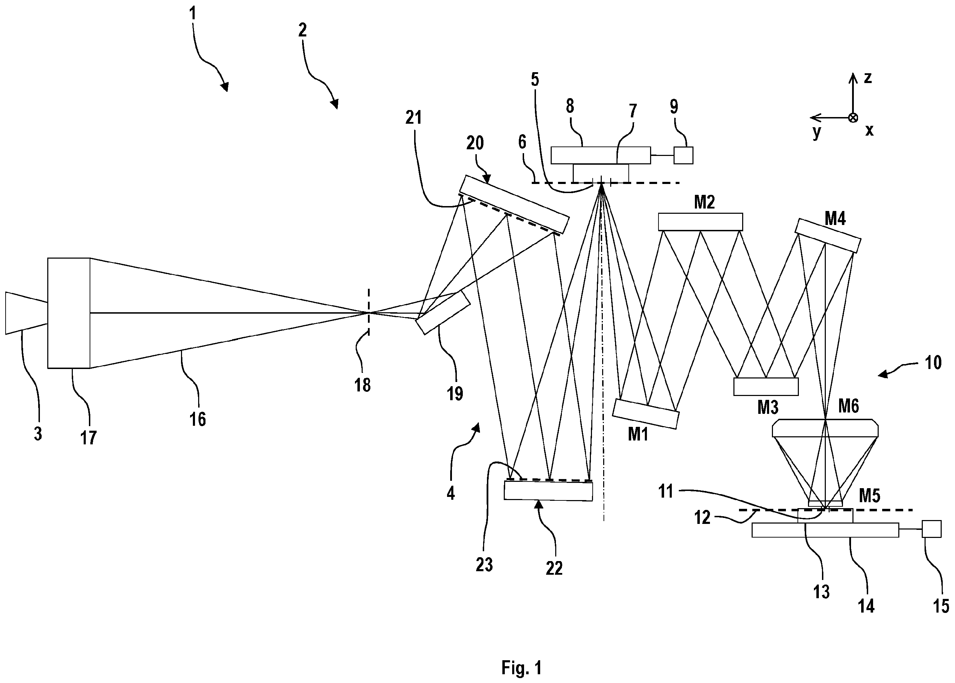

Figure 1 shows an embodiment of a projection exposure apparatus 1 (lithography apparatus), in particular an EUV lithography apparatus. One embodiment of an illumination system 2 of the projection exposure apparatus 1 has, in addition to a light or radiation source 3, an illumination optical unit 4 for illuminating an object field 5 in an object plane 6. In an alternative embodiment, the light source 3 can also be provided as a module separate from the rest of the illumination system 2. In this case, the illumination system 2 does not comprise the light source 3.

A reticle 7 arranged in the object field 5 is exposed. The reticle 7 is held by a reticle holder 8. The reticle holder 8 is displaceable by way of a reticle displacement drive 9, in particular in a scanning direction.

Figure 1 shows, for explanatory purposes, a Cartesian coordinate system with an x-direction x, a y-direction y and a z-direction z. The x-direction x runs perpendicularly into the plane of the drawing. The y-direction y runs horizontally, and the z-direction z runs vertically. The scanning direction in Figure 1 runs along the y-direction y. The z-direction z runs perpendicularly to the object plane 6.

The projection exposure apparatus 1 comprises a projection optical unit 10. The projection optical unit 10 serves for imaging the object field 5 into an image field 11 in an image plane 12. The image plane 12 extends parallel to the object plane 6. Alternatively, an angle between the object plane 6 and the image plane 12 that differs from 0° is also possible.

A structure on the reticle 7 is imaged onto a light-sensitive layer of a wafer 13 arranged in the region of the image field 11 in the image plane 12. The wafer 13 is held by a wafer holder 14. The wafer holder 14 is displaceable by way of a wafer displacement drive 15, in particular along the y-direction y. The displacement, on the one hand, of the reticle 7 by way of the reticle displacement drive 9 and, on the other hand, of the wafer 13 by way of the wafer displacement drive 15 can take place in such a way as to be synchronized with each other.

The light source 3 is an EUV radiation source. The light source 3 emits, in particular, EUV radiation 16, which is also referred to below as used radiation, illumination radiation or illumination light. In particular, the used radiation 16 has a wavelength in the range between 5 nm and 30 nm. The radiation source 3 can be a plasma source, for example an LPP (laser produced plasma) source or a GDPP (gas discharge produced plasma) source. It can also be a synchrotron-based radiation source. The light source 3 can be an FEL (free-electron laser).

The illumination radiation 16 emerging from the light source 3 is focused by a collector 17. The collector 17 can be a collector with one or more ellipsoidal and/or hyperboloidal reflection surfaces. The illumination radiation 16 can be incident on the at least one reflection surface of the collector 17 with grazing incidence (GI), that is to say at angles of incidence of greater than 45°, or with normal incidence (NI), that is to say at angles of incidence of less than 45°. The collector 17 can be structured and/or coated, firstly, for optimizing its reflectivity for the used radiation and, secondly, for suppressing extraneous light.

Downstream of the collector 17, the illumination radiation 16 propagates through an intermediate focus in an intermediate focal plane 18. The intermediate focal plane 18 can represent a separation between a radiation source module, having the light source 3 and the collector 17, and the illumination optical unit 4.

The illumination optical unit 4 comprises a deflection mirror 19 and, arranged downstream thereof in the beam path, a first facet mirror 20. The deflection mirror 19 can be a plane deflection mirror or, alternatively, a mirror with a beam-influencing effect that goes beyond the purely deflecting effect. Alternatively or in addition, the deflection mirror 19 can be in the form of a spectral filter which separates a used light wavelength of the illumination radiation 16 from extraneous light with a wavelength deviating therefrom. If the first facet mirror 20 is arranged in a plane of the illumination optical unit 4 that is optically conjugate to the object plane 6 as a field plane, it is also referred to as a field facet mirror. The first facet mirror 20 comprises a multiplicity of individual first facets 21, which can also be referred to as field facets. Only some of these first facets 21 are shown in Figure 1 by way of example.

The first facets 21 can be in the form of macroscopic facets, in particular as rectangular facets or as facets with an arcuate peripheral contour or a peripheral contour of part of a circle. The first facets 21 may be in the form of plane facets or alternatively as convexly or concavely curved facets.

As known for example from DE 10 2008 009 600 A1, the first facets 21 themselves may also be composed in each case of a multiplicity of individual mirrors, in particular a multiplicity of micromirrors. The first facet mirror 20 can in particular be designed as a microelectromechanical system (MEMS system). For details, reference is made to DE 10 2008 009 600 A1.

Between the collector 17 and the deflection mirror 19, the illumination radiation 16 travels horizontally, that is to say along the y-direction y.

In the beam path of the illumination optical unit 4, a second facet mirror 22 is arranged downstream of the first facet mirror 20. If the second facet mirror 22 is arranged in a pupil plane of the illumination optical unit 4, it is also referred to as a pupil facet mirror. The second facet mirror 22 can also be arranged at a distance from a pupil plane of the illumination optical unit 4. In this case, the combination of the first facet mirror 20 and the second facet mirror 22 is also referred to as a specular reflector. Specular reflectors are known from US 2006/0132747 A1, EP 1 614 008 B1 and US 6,573,978.

The second facet mirror 22 comprises a plurality of second facets 23. In the case of a pupil facet mirror, the second facets 23 are also referred to as pupil facets.

The second facets 23 can likewise be macroscopic facets, which can for example have a round, rectangular or hexagonal periphery, or can alternatively be facets made up of micromirrors. In this regard, reference is likewise made to DE 10 2008 009 600 A1.

The second facets 23 can have plane or alternatively convexly or concavely curved reflection surfaces.

The illumination optical unit 4 consequently forms a doubly faceted system. This fundamental principle is also referred to as a fly's eye condenser (fly's eye integrator).

It can be advantageous to arrange the second facet mirror 22 not exactly within a plane that is optically conjugate to a pupil plane of the projection optical unit 10. In particular, the second facet mirror 22 may be arranged so as to be tilted in relation to a pupil plane of the projection optical unit 10, as is described for example in DE 10 2017 220 586 A1.

With the aid of the second facet mirror 22, the individual first facets 21 are imaged into the object field 5. The second facet mirror 22 is the last beam-shaping mirror or else, in fact, the last mirror for the illumination radiation 16 in the beam path upstream of the object field 5.

In a further embodiment, not shown, of the illumination optical unit 4, a transfer optical unit contributing in particular to the imaging of the first facets 21 into the object field 5 can be arranged in the beam path between the second facet mirror 22 and the object field 5. The transfer optical unit can have exactly one mirror or alternatively have two or more mirrors, which are arranged one behind the other in the beam path of the illumination optical unit 4. The transfer optical unit can in particular comprise one or two normal-incidence mirrors (NI mirrors) and/or one or two grazing-incidence mirrors (GI mirrors).

In the embodiment shown in Figure 1, the illumination optical unit 4 has exactly three mirrors downstream of the collector 17, specifically the deflection mirror 19, the first facet mirror 20 and the second facet mirror 22.

In a further embodiment of the illumination optical unit 4, there is also no need for the deflection mirror 19, and so the illumination optical unit 4 can then have exactly two mirrors downstream of the collector 17, specifically the first facet mirror 20 and the second facet mirror 22.

The imaging of the first facets 21 into the object plane 6 by means of the second facets 23 or using the second facets 23 and a transfer optical unit is often only approximate imaging.

The projection optical unit 10 comprises a plurality of mirrors Mi, which are consecutively numbered in accordance with their arrangement in the beam path of the projection exposure apparatus 1.

In the example shown in Figure 1, the projection optical unit 10 comprises six mirrors M1 to M6. Alternatives with four, eight, ten, twelve or any other number of mirrors Mi are similarly possible. The projection optical unit 10 is a twice-obscured optical unit. The penultimate mirror M5 and the last mirror M6 each have a through opening for the illumination radiation 16. The projection optical unit 10 has an image-side numerical aperture that is greater than 0.5 and may also be greater than 0.6, and may be for example 0.7 or 0.75.

Reflection surfaces of the mirrors Mi can be embodied as free-form surfaces without an axis of rotational symmetry. Alternatively, the reflection surfaces of the mirrors Mi can be designed as aspheric surfaces with exactly one axis of rotational symmetry of the reflection surface shape. Just like the mirrors of the illumination optical unit 4, the mirrors Mi can have highly reflective coatings for the illumination radiation 16. These coatings can be designed as multilayer coatings, in particular with alternating layers of molybdenum and silicon.

The projection optical unit 10 has a large object-image offset in the y-direction y between a y-coordinate of a centre of the object field 5 and a y-coordinate of the centre of the image field 11. In the y-direction y, this object-image offset can be of approximately the same magnitude as a z-distance between the object plane 6 and the image plane 12.

In particular, the projection optical unit 10 can have an anamorphic form. In particular, it has different imaging scales Bx, By in the x- and y-directions x, y. The two imaging scales βx, By of the projection optical unit 10 are preferably (βx, By) = (+/- 0.25, +/- 0.125). A positive imaging scale β means imaging without image inversion. A negative sign for the imaging scale β means imaging with image inversion.

The projection optical unit 10 consequently leads to a reduction in size with a ratio of 4:1 in the x-direction x, that is to say in a direction perpendicular to the scanning direction.

The projection optical unit 10 leads to a reduction in size of 8:1 in the y-direction y, that is to say in the scanning direction.

Other imaging scales are likewise possible. Imaging scales with the same sign and the same absolute value in the x-direction x and y-direction y are also possible, for example with absolute values of 0.125 or of 0.25.

The number of intermediate image planes in the x-direction x and in the y-direction y in the beam path between the object field 5 and the image field 11 can be the same or can differ, depending on the embodiment of the projection optical unit 10. Examples of projection optical units with different numbers of such intermediate images in the x- and y-directions x, y are known from US 2018/0074303 A1.

In each case one of the second facets 23 is assigned to exactly one of the first facets 21 for respectively forming an illumination channel for illuminating the object field 5. This may in particular produce illumination according to the Köhler principle. The far field is decomposed into a multiplicity of object fields 5 with the aid of the first facets 21. The first facets 21 produce a plurality of images of the intermediate focus on the second facets 23 respectively assigned to them.

By way of an assigned second facet 23, the first facets 21 are in each case imaged onto the reticle 7 in a manner overlaid on one another for the purposes of illuminating the object field 5. The illumination of the object field 5 is in particular as homogeneous as possible. It preferably has a uniformity error of less than 2%. The field uniformity can be achieved by way of the overlay of different illumination channels.

The full-area illumination of the entrance pupil of the projection optical unit 10 can be defined geometrically by an arrangement of the second facets 23. The intensity distribution in the entrance pupil of the projection optical unit 10 can be set by selecting the illumination channels, in particular the subset of the second facets 23, which guide light. This intensity distribution is also referred to as illumination setting or illumination pupil filling.

A likewise preferred pupil uniformity in the region of sections of an illumination pupil of the illumination optical unit 4 which are illuminated in a defined manner can be achieved by a redistribution of the illumination channels.

Further aspects and details of the illumination of the object field 5 and in particular of the entrance pupil of the projection optical unit 10 are described below.

In particular, the projection optical unit 10 can have a homocentric entrance pupil. The latter can be accessible. It can also be inaccessible.

The entrance pupil of the projection optical unit 10 frequently cannot be exactly illuminated with the second facet mirror 22. When imaging the projection optical unit 10, which images the centre of the second facet mirror 22 telecentrically onto the wafer 13, the aperture rays often do not intersect at a single point. However, it is possible to find an area in which the distance of the aperture rays determined in pairs becomes minimal. This area represents the entrance pupil or an area in real space that is conjugate thereto. In particular, this area has a finite curvature.

It may be the case that the projection optical unit 10 has different poses of the entrance pupil for the tangential beam path and for the sagittal beam path. In this case, an imaging element, in particular an optical component of the transfer optical unit, should be provided between the second facet mirror 22 and the reticle 7. With the aid of this optical element, the different poses of the tangential entrance pupil and the sagittal entrance pupil can be taken into account.

In the arrangement of the components of the illumination optical unit 4 shown in Figure 1, the second facet mirror 22 is arranged in an area conjugate to the entrance pupil of the projection optical unit 10. The first facet mirror 20 is arranged so as to be tilted in relation to the object plane 6. The first facet mirror 20 is arranged so as to be tilted in relation to an arrangement plane defined by the deflection mirror 19. The first facet mirror 20 is arranged in tilted fashion with respect to an arrangement plane defined by the second facet mirror 22.

Mirrors M1 to M6 which are each actively manipulable in six degrees of freedom with the aid of manipulators are used in the projection optical unit 10. In this case, three translational degrees of freedom are respectively provided along the x-direction x, the y-direction y and the z-direction z. Further, three rotational degrees of freedom are also respectively provided around the x-direction x, the y-direction y and the z-direction z.

The "position" of such a mirror M1 to M6 is to be understood as its coordinates or the coordinates of a measurement point provided on the respective mirror M1 to M6 with respect to the x-direction x, the y-direction y and the z-direction z. The "orientation" is to be understood to mean the tilt of the respective mirror M1 to M6 about the x-direction x, the y-direction y and the z-direction z. The "pose" of such a mirror M1 to M6 is to be understood to mean both its position and its orientation. "Adjusting" or "aligning" a mirror M1 to M6 should be understood to mean moving same from an actual pose to a target pose.

The task of the manipulators is, inter alia, to keep the position and orientation of the respective mirror M1 to M6 stable such that image errors, in particular the overlay error or a line-of-sight error, remain minimal. This requires a high control bandwidth of the mirrors M1 to M6 in order to suppress external influences and reduce the overlay error.

The trend in future projection optical units 10 for the EUV range is towards high numerical apertures (NA). The expectation is therefore that the optical surfaces, and hence the mirrors M1 to M6, will become larger. This trend makes the object of a high control bandwidth more difficult since the latter depends, inter alia, on the first internal natural frequency of the respective mirror body. Low natural frequencies lead to the sensors required for the closed-loop control starting to vibrate in the low frequency range. Consequently, the rigid body closed-loop control is already unstable at low frequencies.

One can show that the first natural frequency *ω* of a cylindrical mirror body is proportional to a thickness d of the respective mirror M1 to M6 and inversely proportional to the square of a radius r of the optical surface. This is due to the fact that the mass is proportional to d*r² and the stiffness is proportional to d³/r². An optically active surface with the radius r therefore requires a mirror body volume proportional to r⁴ if the first natural frequency, and hence the control bandwidth of the mirror M1 to M6, may not be reduced. Since material costs are proportional to the substrate volume, the demand for a high control bandwidth becomes ever more expensive. This needs to be improved.

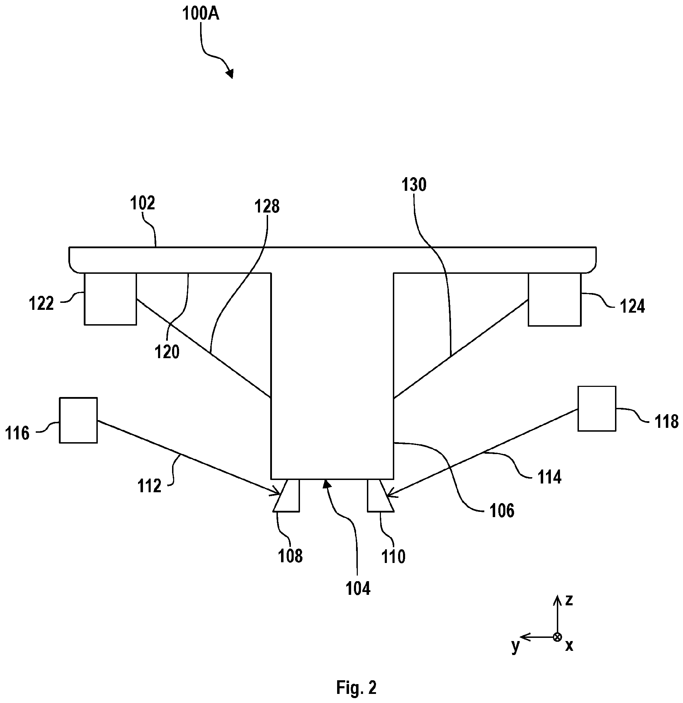

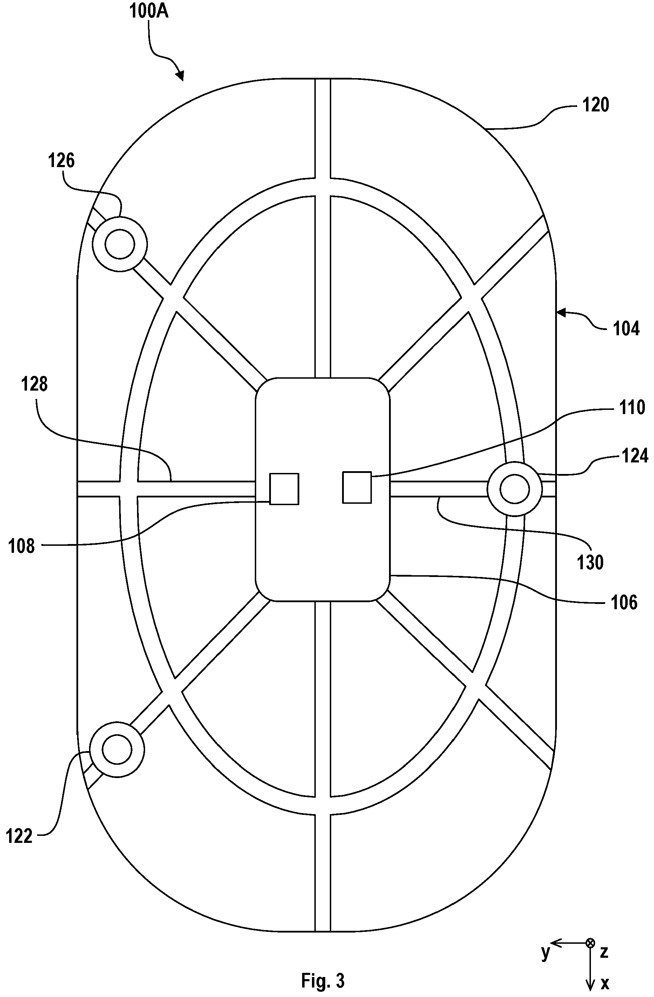

Figure 2 shows a schematic view of one embodiment of an optical element 100A. Figure 3 shows a schematic bottom view of the optical element 100A. Reference is made below to Figures 2 and 3 simultaneously.

The optical element 100A can be a mirror. In particular, the optical element 100A can be one of the mirrors M1 to M6. The optical element 100A comprises an optical active surface 102. The optically active surface 102 is suitable for reflecting EUV radiation. The optically active surface 102 is a mirror surface. The optically active surface 102 is provided on the front side of a mirror body 104 of the optical element 100A. The mirror body 104 can also be referred to as mirror substrate. For example, the mirror body 104 element is made from ceramics or glass-ceramics.

The mirror body 104 comprises a block-shaped base portion 106. The base portion may have a cylindrical geometry with an oval or circular base. The base portion 106 can have any desired geometry. The base portion 106 is in the form of a solid body and has high stiffness as a result. The base portion 106 may be provided approximately centrally on the mirror body 104.

On account of the high stiffness of the base portion 106 in comparison with the remaining mirror body 104, sensors or, as shown in Figures 2 and 3, a sensor system 108, 110 are/is attached to the base portion 106, preferably in the form of measurement targets. The sensor system 108, 110 in the form of the measurement targets may comprise mirrors. By way of example, measuring beams 112, 114 of a measuring instrument 116, 118 may be steered to the sensor system 108, 110. The pose of the optical element 100A can be detected with the aid of the sensor system 108, 110 and the measuring instrument or instruments 116, 118.

In addition to the base portion 106 the optical element 100A comprises a slab-shaped or panel-shaped edge portion 120. Considered along the z-direction z, the edge portion 120 has substantially lower material strength than the base portion 106. In the plan view, the edge portion 120 can be oval or triangular, for example. The edge portion 120 may encircle the entirety of the base portion 106 such that a mushroom-shaped geometry of the mirror body 104 arises in the view in accordance with Figure 2.

The edge portion 120 and the base portion 106 are formed in one piece, in particular materially in one piece. "One-piece" or "in one piece" in this case means that the edge portion 120 and the base portion 106 are not constructed from different components but form a common component. In the present case, "materially in one piece" means that the edge portion 120 and the base portion 106 are manufactured from the same material throughout. Consequently, the mirror body 104 is monolithic or can be referred to as monolithic. By way of example, the mirror body 104 is produced by suitable grinding of a substrate block. The optical active surface 102 can be produced by way of coating.

As a result of the edge portion 120 having a thinner wall in comparison with the base portion 106, the edge portion 120 is softer or less stiff. Actuator connectors 122, 124, 126 are provided on the edge portion 120. By way of example, three actuator connectors 122, 124, 126 are provided, and are arranged in the form of a triangle. Actuators are connected to the actuator connectors 122, 124, 126. The actuators connected to the actuator connectors 122, 124, 126 can be what are known as Lorentz actuators for example. However, other actuators may also be used. The pose of the optical element 100A can be adjusted with the aid of the actuators.

A significant reduction in mass can be achieved by designing the edge portion 120 to have a thinner wall in comparison with the base portion 106. Vibrations as a consequence of exciting the natural modes of the edge portion 120 will not impair the stability of the sensor system 108, 110 provided on the base portion 106. Moreover, the actuators are advantageously connected to the edge portion 120 with the aid of the actuator connectors 122, 124, 126, in order to facilitate decoupling of parasitic forces and torques.

Further, rib structures 128, 130 are provided, said rib structures supporting the edge portion 120 on the base portion 106. The rib structures 128, 130 can extend as desired along the x-direction x, the y-direction y and/or the z-direction z, and can also branch out as desired. The rib structures 128, 130 can be of honeycomb form. The rib structures 128, 130 ensure a certain amount of stiffening of the edge portion 120, and hence of the entire mirror body 104. The rib structures 128, 130 are part of the mirror body 104.

The rib structures 128, 130 moreover offer the option of attaching tuned mass dampers (TMDs) in order to damp certain natural modes. Where necessary, it is likewise possible to stiffen individual actuator connectors 122, 124, 126 with the aid of the rib structures 128, 130. The rib structures 128, 130 are also formed in one piece with the base portion 106 and the edge portion 120. Using the optical element 100A explained above, it is possible to obtain higher control bandwidths with lower masses of the mirror body 104 in comparison with known mirrors for projection optical units 10.

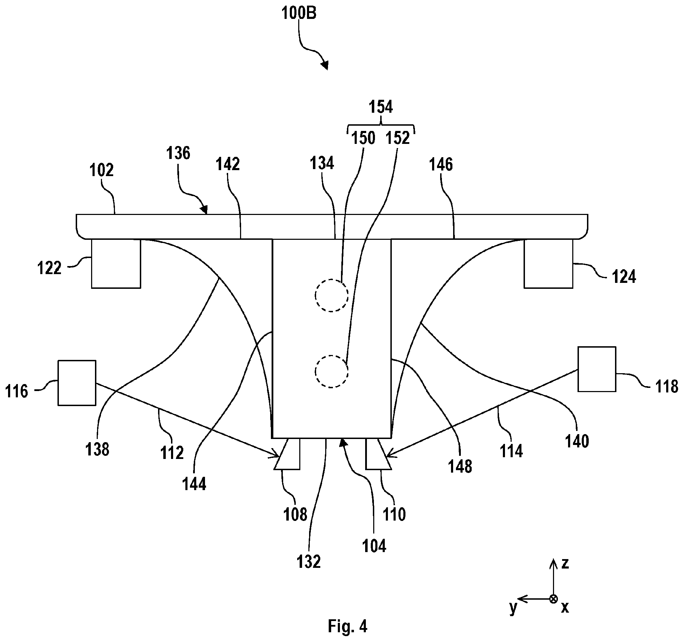

Figure 4 shows a schematic view of a further embodiment of an optical element 100B. The optical element 100B essentially differs from the optical element 100A in that the optical element 100B does not have a monolithic or one-piece mirror body 104. The optical element 100B comprises a solid base portion 132, which is bonded to an edge portion 136 at an end-side bonding surface 134. The edge portion 136 comprises the optically active surface 102. In comparison with the solid base portion 132, the edge portion 136 has a significantly thinner wall, and hence is softer or less stiff. Further, stiffening rib structures 138, 140 are provided, which rib structures are bonded to the base portion 132 and the edge portion 136 with the aid of bonding surfaces 142, 144, 146, 148. Together, the base portion 132, the edge portion 136 and the rib structures 138, 144 make a multi-part mirror body 104 of the optical element 100B.

As mentioned previously, the optical element 100B is composed of a plurality of components, specifically the base portion 132, the edge portion 136 and the rib structures 138, 140, and consequently does not have a monolithic structure. From this, there advantageously is the option of manufacturing the components from different materials. By way of example, it is possible to use materials with different coefficients of thermal expansion (CTEs).

By way of example, one component of the optical element may consist of a 0-CTE-material and at least one further component may be manufactured from an easily processable and cost-effective material, which is suitable for a light structure. Ceramic materials are particularly well-suited in this case. In this case, it is possible to provide active cooling in order to compensate the CTE difference between the various materials. Both components can either be bonded or adhesively bonded. Furthermore, the optical element 100B may be composed of many simple individual parts. Various joining methods are possible to this end. By way of example, it is possible to use adhesion, screen printing, laser bonding, surface activated bonding, and not a bonding, glass frit bonding, adhesive bonding, eutectic bonding, reactive bonding, silicate bonding or the like.

By way of example, the aforementioned active cooling can be realized or implemented by virtue of the optical element 100B or the mirror body 104 having cooling channels 150, 152 through which a coolant, for example water, is guided in order to cool or heat the optical element 100B. In this case, "active" means that the coolant is pumped through the cooling channels 150, 152 with the aid of a pump or the like in order to extract heat from or supply heat to the optical element 110B. However, heat is preferably extracted from the optical element 100B in order to cool said optical element. The active cooling is presently explained only in relation to the optical element 100B. The explanations relating to the active cooling of the optical element 100B are however also applicable accordingly to the optical element 100A.

By way of example, the cooling channels 150, 152 are provided in the base portion 132. However, the cooling channels 150, 152 may also be provided in the edge portion 136 and/or in the rib structures 138, 140. Any desired number of cooling channels 150, 152 may be provided. The cooling channels 150, 152 form a cooling circuit 154 or are part of a cooling circuit 154. The cooling circuit 154 may comprise the aforementioned pump. The coolant circulates in the cooling circuit 154.

Although the present invention has been described on the basis of exemplary embodiments, it can be modified in various ways.

### LIST OF REFERENCE SIGNS

- 1: Projection exposure apparatus
- 2: Illumination system
- 3: Light source
- 4: Illumination optical unit
- 5: Object field
- 6: Object plane
- 7: Reticle
- 8: Reticle holder
- 9: Reticle displacement drive
- 10: Projection optical unit
- 11: Image field
- 12: Image plane
- 13: Wafer
- 14: Wafer holder
- 15: Wafer displacement drive
- 16: Illumination radiation
- 17: Collector
- 18: Intermediate focal plane
- 19: Deflection mirror
- 20: First facet mirror
- 21: First facet
- 22: Second facet mirror
- 23: Second facet
- 100A: Optical element
- 100B: Optical element
- 102: Optically active surface
- 104: Mirror body
- 106: Base portion
- 108: Sensor system
- 110: Sensor system
- 112: Measuring beam
- 114: Measuring beam
- 116: Measuring instrument
- 118: Measuring instrument
- 120: Edge portion
- 122: Actuator connector
- 124: Actuator connector
- 126: Actuator connector
- 128: Rib structure
- 130: Rib structure
- 132: Base portion
- 134: Bonding surface
- 136: Edge portion
- 138: Rib structure
- 140: Rib structure
- 142: Bonding surface
- 144: Bonding surface
- 146: Bonding surface
- 148: Bonding surface
- 150: Cooling channel
- 152: Cooling channel
- 154: Cooling circuit

- M1: Mirror
- M2: Mirror
- M3: Mirror
- M4: Mirror
- M5: Mirror
- M6: Mirror
- x: x-direction
- y: y-direction
- z: z-direction

## Claims

1. Optical element (100A, 100B) for a projection exposure apparatus (1), comprising
a mirror body (104) having an optically active surface (102), the mirror body (104) comprising a base portion (106, 132) which carries a sensor system (108, 110) and an edge portion (120, 136) on which actuator connectors (122, 124, 126) for connecting actuators to the optical element (100A, 100B) are provided,
**characterized in that**
the base portion (106, 132) has a greater stiffness in comparison with the edge portion (120, 136), and
the mirror body (104) comprises a stiffening rib structure (128, 130, 138, 140) attached to the edge portion (120, 136) on a back side thereof, wherein the back side faces away from the optically active surface (102), and wherein the rib structure (128, 130, 138, 140) supports the edge portion (120, 136) on the base portion (106).

2. Optical element according to Claim 1, wherein the optically active surface (102) is provided on the front side of the edge portion (120, 136) and wherein the actuator connectors (122, 124, 126) are provided on the back side of the edge portion (120, 136).

3. Optical element according to Claim 1 or 2, wherein the rib structure (128, 130, 138, 140) comprises a honeycomb geometry.

4. Optical element according to any one of Claims 1-3, wherein the rib structure (128, 130, 138, 140) is connected to the actuator connectors (122, 124, 126) in order to stiffen the latter.

5. Optical element according to any one of Claims 1-4, wherein the sensor system (108, 110) comprises measurement targets that are configured to interact with a measuring beam (112, 114) of a measuring instrument (116, 118).

6. Optical element according to any one of Claims 1-5, wherein the actuator connectors (122, 124, 126) are provided at the edge of the edge portion (120, 136).

7. Optical element according to any one of Claims 1-6, wherein the edge portion (120, 136) is slab-shaped and wherein the base portion (106, 132) is block-shaped.

8. Optical element according to any one of Claims 1-7, wherein the edge portion (120, 136) has a thinner wall than the base portion (106, 132).

9. Optical element according to any one of Claims 1-8, wherein the mirror body (104) is a monolithic component or a multi-part component.

10. Optical element according to Claim 9, wherein the base portion (132) and the edge portion (136) are bonded to one another at a bonding surface (134) in the case where the mirror body (104) is a multi-part component.

11. Optical element according to any one of Claims 1-10, wherein the mirror body (104) is actively cooled.

12. Optical element according to Claim 11, wherein cooling channels (150, 152) are guided through the mirror body (104) for the purposes of actively cooling the mirror body (104).

13. Projection optical unit (10) for a projection exposure apparatus (1) having at least one optical element (100A, 100B) according to any one of Claims 1-12 and a plurality of actuators which are connected to the actuator connectors (122, 124, 126) for the purposes of adjusting the optical element (100A, 100B).

14. Projection exposure apparatus (1) having at least one optical element (100A, 100B) according to any one of Claims 1-12 and/or a projection optical unit (10) according to Claim 13.

## Patentansprüche

1. Optisches Element (100A, 100B) für eine Projektionsbelichtungseinrichtung (1), umfassend
einen Spiegelkörper (104) mit einer optisch aktiven Oberfläche (102), wobei der Spiegelkörper (104) einen Basisabschnitt (106, 132), der ein Sensorsystem (108, 110) trägt, und einen Randabschnitt (120, 136) umfasst, auf dem Aktuatorverbinder (122, 124, 126) zum Verbinden von Aktuatoren mit dem optischen Element (100A, 100B) bereitgestellt sind,
**dadurch gekennzeichnet, dass**
der Basisabschnitt (106, 132) eine größere Steifigkeit im Vergleich zu dem Randabschnitt (120, 136) aufweist, und
der Spiegelkörper (104) eine Versteifungsrippenstruktur (128, 130, 138, 140) umfasst, die an dem Randabschnitt (120, 136) auf einer Rückseite davon angebracht ist, wobei die Rückseite von der optisch aktiven Oberfläche (102) weg weist und wobei die Rippenstruktur (128, 130, 138, 140) den Randabschnitt (120, 136) auf dem Basisabschnitt (106) stützt.

2. Optisches Element nach Anspruch 1, wobei die optisch aktive Oberfläche (102) auf der Vorderseite des Randabschnitts (120, 136) bereitgestellt ist und wobei die Aktuatorverbinder (122, 124, 126) auf der Rückseite des Randabschnitts (120, 136) bereitgestellt sind.

3. Optisches Element nach Anspruch 1 oder 2, wobei die Rippenstruktur (128, 130, 138, 140) eine Wabengeometrie umfasst.

4. Optisches Element nach einem der Ansprüche 1-3, wobei die Rippenstruktur (128, 130, 138, 140) mit den Aktuatorverbindern (122, 124, 126) verbunden ist, um diese zu versteifen.

5. Optisches Element nach einem der Ansprüche 1-4, wobei das Sensorsystem (108, 110) Messziele umfasst, die dazu ausgelegt sind, mit einem Messstrahl (112, 114) eines Messgeräts (116, 118) zu interagieren.

6. Optisches Element nach einem der Ansprüche 1-5, wobei die Aktuatorverbinder (122, 124, 126) an dem Rand des Randabschnitts (120, 136) bereitgestellt sind.

7. Optisches Element nach einem der Ansprüche 1-6, wobei der Randabschnitt (120, 136) plattenförmig ist und wobei der Basisabschnitt (106, 132) blockförmig ist.

8. Optisches Element nach einem der Ansprüche 1-7, wobei der Randabschnitt (120, 136) eine dünnere Wand als der Basisabschnitt (106, 132) aufweist.

9. Optisches Element nach einem der Ansprüche 1-8, wobei der Spiegelkörper (104) eine monolithische Komponente oder eine mehrteilige Komponente ist.

10. Optisches Element nach Anspruch 9, wobei der Basisabschnitt (132) und der Randabschnitt (136) an einer Bondfläche (134) aneinander gebondet sind, falls der Spiegelkörper (104) eine mehrteilige Komponente ist.

11. Optisches Element nach einem der Ansprüche 1-10, wobei der Spiegelkörper (104) aktiv gekühlt wird.

12. Optisches Element nach Anspruch 11, wobei Kühlkanäle (150, 152) durch den Spiegelkörper (104) zur aktiven Kühlung des Spiegelkörpers (104) geführt sind.

13. Optische Projektionseinheit (10) für eine Projektionsbelichtungseinrichtung (1) mit mindestens einem optischen Element (100A, 100B) nach einem der Ansprüche 1-12 und mehreren Aktuatoren, die mit den Aktuatorverbindern (122, 124, 126) zum Anpassen des optischen Elements (100A, 100B) verbunden sind.

14. Projektionsbelichtungseinrichtung (1) mit mindestens einem optischen Element (100A, 100B) nach einem der Ansprüche 1-12 und/oder einer optischen Projektionseinheit (10) nach Anspruch 13.

## Revendications

1. Élément optique (100A, 100B) pour un appareil d'exposition par projection (1), comprenant
un corps de miroir (104) comportant une surface optiquement active (102), le corps de miroir (104) comprenant une partie de base (106, 132) qui porte un système de capteurs (108, 110) et une partie de bord (120, 136) sur laquelle sont disposés des connecteurs d'actionneur (122, 124, 126) destinés à connecter des actionneurs à l'élément optique (100A, 100B),
**caractérisé en ce que**
la partie de base (106, 132) présente une rigidité supérieure à celle de la partie de bord (120, 136), et
le corps de miroir (104) comprend une structure de nervures de rigidification (128, 130, 138, 140) fixée à la partie de bord (120, 136) sur une face arrière de celle-ci, la face arrière tournant le dos à la surface optiquement active (102), et la structure de nervures (128, 130, 138, 140) faisant supporter la partie de bord (120, 136) sur la partie de base (106).

2. Élément optique selon la revendication 1, dans lequel la surface optiquement active (102) est disposée sur la face avant de la partie de bord (120, 136) et dans lequel les connecteurs d'actionneur (122, 124, 126) sont disposés sur la face arrière de la partie de bord (120, 136).

3. Élément optique selon la revendication 1 ou 2, dans lequel la structure de nervures (128, 130, 138, 140) présente une géométrie en nid d'abeilles.

4. Élément optique selon l'une quelconque des revendications 1 à 3, dans lequel la structure de nervures (128, 130, 138, 140) est reliée aux connecteurs d'actionneur (122, 124, 126) afin de rigidifier ces derniers.

5. Élément optique selon l'une quelconque des revendications 1 à 4, dans lequel le système de capteurs (108, 110) comprend des cibles de mesure qui sont conçues pour interagir avec un faisceau de mesure (112, 114) d'un instrument de mesure (116, 118).

6. Élément optique selon l'une quelconque des revendications 1 à 5, dans lequel les connecteurs d'actionneur (122, 124, 126) sont disposés au bord de la partie de bord (120, 136).

7. Élément optique selon l'une quelconque des revendications 1 à 6, dans lequel la partie de bord (120, 136) prend la forme d'une plaque et dans lequel la partie de base (106, 132) prend la forme d'un bloc.

8. Élément optique selon l'une quelconque des revendications 1 à 7, dans lequel la partie de bord (120, 136) comporte une paroi plus mince que la partie de base (106, 132).

9. Élément optique selon l'une quelconque des revendications 1 à 8, dans lequel le corps de miroir (104) est un composant monolithique ou un composant en plusieurs parties.

10. Élément optique selon la revendication 9, dans lequel la partie de base (132) et la partie de bord (136) sont assemblées l'une à l'autre au niveau d'une surface d'assemblage (134) dans le cas où le corps de miroir (104) est un composant en plusieurs parties.

11. Élément optique selon l'une quelconque des revendications 1 à 10, dans lequel le corps de miroir (104) est refroidi activement.

12. Élément optique selon la revendication 11, dans lequel des canaux de refroidissement (150, 152) sont guidés à travers le corps de miroir (104) dans le but de refroidir activement le corps de miroir (104).

13. Unité optique de projection (10) pour un appareil d'exposition par projection (1) comportant au moins un élément optique (100A, 100B) selon l'une quelconque des revendications 1 à 12 et une pluralité d'actionneurs qui sont connectés aux connecteurs d'actionneur (122, 124, 126) dans le but de régler l'élément optique (100A, 100B).

14. Appareil d'exposition par projection (1) comportant au moins un élément optique (100A, 100B) selon l'une quelconque des revendications 1 à 12 et/ou une unité optique de projection (10) selon la revendication 13.
